# FASCICULE DE BREVET EUROPEEN

(11) **EP 1 903 000 B1**
(45) Date de publication et mention de la délivrance du brevet: **18.09.2019**
(21) Numéro de dépôt: 07291120.9
(22) Date de dépôt: 21.09.2007
(51) Int. Cl.: B81B 7/00

(54) **Composant biocompatible implantable incorporant un élément actif intégré tel qu'un capteur de mesure d'un paramètre physiologique, microsystème électromécanique ou circuit électronique**
Implantierbares biokompatibles Bauteil, das ein aktives integriertes Element wie etwa einen Messfühler für einen physiologischen Parameter, ein elektromechanisches Mikrosystem oder einen elektronischen Schaltkreis umfasst
Implantable biocompatible component including an integrated active element such as a sensor for measuring a physiological parameter, electromechanical microsystem or electronic circuit

(30) Priorité: 25.09.2006 FR 0608369
(43) Date de publication de la demande: 26.03.2008
(73) Titulaire: Sorin CRM SAS, 92140 Clamart (FR)
(72) Inventeur: Dal Molin, Renzo, 92320 Châtillon (FR); Ripart, Alain, 91190 Gif Sur Yvette (FR)
(74) Mandataire: Grünecker Patent- und Rechtsanwälte PartG mbB

(56) Documents cités:
- WO-A-2004/035461
- US-A- 4 023 562
- US-A1- 2003 209 357
- US-A1- 2006 174 712
- US-A1- 2006 192 272

## Description

L'invention concerne, de façon générale, le domaine des "dispositifs médicaux actifs" tels que définis par la directive 93/42/CE du 14 juin 1993 du Conseil des communautés européennes, et notamment les "dispositifs médicaux implantables actifs" tels que définis par la directive du Conseil 90/385/CEE du 20 juin 1990.

Cette définition inclut en particulier les appareils chargés de surveiller l'activité cardiaque et de générer des impulsions de stimulation, de resynchronisation, de défibrillation et/ou de cardioversion en cas de trouble du rythme détecté par l'appareil. Elle inclut aussi les appareils neurologiques, les pompes de diffusion de substances médicales, les implants cochléaires, les capteurs biologiques implantés, etc., ainsi que les dispositifs de mesure de pH ou encore d'impédance intracorporelle (telle que mesure d'impédance transpulmonaire ou d'impédance intracardiaque).

Les dispositifs médicaux implantables actifs font appel, pour le recueil des signaux et le pilotage des diverses fonctions, à des capteurs qui peuvent être notamment intégrés à une sonde elle-même reliée à un boîtier de générateur du dispositif. Des exemples typiques de tels capteurs sont les capteurs de pression sanguine ou d'accélération endocardiaque (EA) montés à l'extrémité distale d'une sonde endocavitaire introduite dans le myocarde et reliée au boîtier d'un stimulateur ou défibrillateur.

L'invention concerne plus précisément un composant biocompatible implantable dans le corps humain, qui incorpore un élément actif encapsulé de manière hermétique tel qu'un capteur de mesure d'un paramètre physiologique, un microsystème électromécanique ou un circuit électronique intégré

Par commodité, cet élément actif sera désigné par la suite simplement "capteur", mais l'invention ne doit pas être entendue de manière limitative et on comprendra qu'elle couvre non seulement les capteurs proprement dits, c'est-à-dire les transducteurs de signal permettant de produire un signal électrique fonction des variations d'un paramètre physique, mais également les circuits électroniques actifs tels qu'amplificateurs, filtres, ... associés ou non à un capteur pour être disposés à proximité de ce dernier, ou encore les microsystèmes électromécaniques (MEMS), et de façon générale tout élément technologiquement intégrable sur un substrat en un matériau tel que le silicium ou autre matériau semiconducteur.

Les capteurs implantés sont soumis à des exigences très strictes, en particulier lorsqu'ils sont en contact avec le sang ou d'autres fluides corporels, surtout lorsque ce contact est permanent, sur une durée pouvant atteindre plusieurs années dans le cas des implants cardiaques.

Ces exigences, qui sont notamment développées dans la norme ISO 10993, sont de deux ordres :
- biocompatibilité des matériaux employés, c'est-à-dire que ces matériaux doivent rester totalement inertes à l'égard des tissus et fluides corporels environnants (innocuité) et, inversement, ces tissus ou fluides ne doivent entraîner aucune corrosion ou dégradation des propriétés des matériaux, qui doivent rester intacts en dépit du contact prolongé avec le milieu biologique environnant.
- herméticité, c'est-à-dire que le capteur doit être résistant non seulement à la pénétration des liquides (étanchéité), mais également à celle des gaz, ce qui suppose un taux de fuite parfaitement contrôlé et infinitésimal.

Longtemps, il a suffi d'enrober le capteur dans un matériau biocompatible, mais certaines normes plus récentes exigent dorénavant un double niveau de protection, avec une biocompatibilité non seulement au niveau de l'enrobage, mais également pour l'élément situé sous celui-ci. Il s'agit d'assurer la protection même en cas de contact indirect, par exemple du fait d'une diffusion au travers de l'enrobage entre le capteur et le milieu environnant, ou encore en cas de dégradation, blessure, fissuration, ... de l'enrobage après une période prolongée.

Pour répondre à ces exigences très strictes, la solution actuelle consiste à incorporer le capteur dans un boîtier en métal inerte, généralement en titane. Des traversées en céramique soudées sur le boîtier permettent d'établir les liaisons électriques entre le capteur enfermé dans le boîtier et l'extérieur afin d'établir la connexion aux conducteurs internes de la sonde.

Cette solution répond parfaitement aux exigences de biocompatibilité et d'herméticité exposées plus haut.

En revanche, elle est coûteuse, en raison de la technologie délicate à mettre en oeuvre, du recours à des composants coûteux et difficiles à assembler, et à l'impossibilité d'un traitement automatisé, à plus forte raison d'un traitement collectif, qui permettrait une production en série.

De plus, cette technique conduit à des composants relativement volumineux, en raison du recours à un boîtier qui ne peut pas être miniaturisé autant que cela serait souhaitable. Or il existe un besoin de capteurs de très faibles dimensions qui puissent être notamment placés sur des sondes de faible diamètre, compatibles avec une mise en place par les techniques habituelles de cathéterisation du réseau veineux.

Le but de l'invention est de proposer un composant incluant un capteur (ou autre élément actif) évitant le recours à un boîtier titane et à des traversées pour la liaison électrique, qui puisse néanmoins assurer parfaitement une biocompatibilité et une herméticité au degré requis par les contraintes très strictes résultant du caractère implantable de ce composant et de la nécessité de résister à un contact prolongé avec les tissus et fluides corporels tels que le sang.

L'invention a notamment pour but de garantir ces performances de biocompatibilité et d'herméticité sur une très longue durée, typiquement de plusieurs années dans le cas des implants cardiaques.

Un autre but de l'invention est de permettre un abaissement des coûts de fabrication d'un tel composant, par mise en oeuvre de technologies par ailleurs éprouvées, en offrant également une possibilité de fabrication par traitement collectif.

Un autre but encore de l'invention est de proposer un tel composant présentant une miniaturisation poussée, permettant notamment de placer un ou plusieurs de ces composants sur des sondes de faible diamètre.

Un autre but encore de l'invention est de proposer un composant de ce type dont la configuration permette sa téléalimentation et l'échange de données par voie non galvanique, typiquement par une liaison RF, sans accroissement indu de la complexité technologique.

Le US 4 023 562 A1 décrit un capteur de pression intégré dans un substrat, encapsulé sous un couvercle permettant d'obtenir un ensemble dont la biocompatibilité permet par exemple de l'introduire dans un cathéter lors d'une intervention pour mesurer une pression en un emplacement donné du corps humain.

La configuration décrite par ce document n'est toutefois pas adaptée aux buts énoncés ci-dessus : notamment, elle ne procure pas de biocompatibilité et d'herméticité sur une très longue durée, et n'offre pas la possibilité d'une fabrication collective.

En effet, dans ce document, la prise de contact avec les bornes du capteur se fait par des plages métallisées disposées sur le côté du couvercle, dans le même plan que le composant ; la liaison électrique est réalisée par une tranchée horizontale, formée également dans ce plan, avec une diffusion au bore pour la rendre conductrice. Cette technique ne permet pas d'obtenir des contacts de faible résistance, car la résistivité d'une diffusion au bore est notablement supérieure à celle d'un métal. Au surplus, la technique proposée ne permet pas un traitement collectif des plaquettes d'une même tranche de silicium, dans la mesure où il n'est pas possible de scier simultanément le substrat de base et le capot en raison de la prise de contact latérale.

Au surplus, le silicium du substrat et du capot est dopé au phosphore, ce qui ne lui confère pas de biocompatibilité à long terme, et rend ce composant utilisable seulement pour des interventions de relativement courte durée (quelques heures, tout au plus quelques jours).

Le US 2003/0209357 A1 décrit une technique consistant à reporter un composant sur un substrat, puis à encapsuler le tout avec un capot de silicium. La prise de contact est opérée par la face opposée du substrat sur lequel est rapporté le composant MEMS. Pour cela, le substrat est creusé largement par attaque au KOH, de part en part, jusqu'à une métallisation présente sur la face opposée ; la liaison électrique est obtenue en tapissant la paroi de ces trous d'une métallisation.

Du fait notamment des trous traversants de grande dimension, le composant obtenu n'est pas susceptible de procurer l'herméticité nécessaire à un implant corporel (ce n'est d'ailleurs pas l'application visée par ce document).

Au surplus, la nécessité de reporter un composant sur le substrat, outre l'augmentation de taille, ne permet pas de traitement collectif susceptible d'abaisser le coût de fabrication.

Pour atteindre les buts énoncés ci-dessus, l'invention propose un composant du type général divulgué par le US4 023 562 A1 précité, correspondant au préambule de la revendication 1, et comprenant en outre les caractéristiques additionnelles énoncées dans la partie caractérisante de cette revendication 1, de manière à le rendre biocompatible et implantable dans le corps humain. Les sous-revendications visent des formes de réalisation subsidiaires avantageuses.

On va maintenant décrire un exemple de mise en oeuvre du dispositif de l'invention, en référence aux dessins annexés où les mêmes références numériques désignent d'une figure à l'autre des éléments identiques ou fonctionnellement semblables. Les figures décrivent des composants qui ne font pas partie de l'invention, mais qui sont présentés pour une meilleure compréhension de celle-ci.
La figure 1 est une vue en coupe schématique d'un composant où substrat et boîtier sont directement scellés l'un à l'autre.
La figure 2 est une variante de la figure 1, où substrat et couvercle sont soudés avec interposition d'un anneau de scellement approprié.
La figure 3 illustre une variante de la figure 2, adaptée à la réalisation d'un composant pourvu de fonctions RF.
La figure 4 illustre les différentes étapes d'un procédé de type *"Thin Film Packaging"* (TFP).
La figure 5 est une vue en plan du composant monté sur un support avec sa connectique adaptée.

Le composant de l'invention est un composant biocompatible implantable dans le corps humain incorporant, encapsulé de manière hermétique, un élément de type capteur de mesure d'un paramètre physiologique, microsystème électromécanique ou circuit électronique, ce composant comprenant :
- un substrat de base (12) en silicium intégrant sur l'une de ses faces l'élément (14), et pourvu de plages métalliques biocompatibles (16), biocompatibles avec l'environnement extérieur, formées sur une surface libre de ce même substrat, ces plages étant électriquement reliées à l'élément par des liaisons électriques (20) intégrées au substrat, et
- un couvercle en silicium (22) recouvrant et fermant périphériquement le substrat de manière hermétique, du coté de la face intégrant l'élément, ce composant étant essentiellement dépourvu de boîtier métallique d'isolement de l'élément d'avec l'environnement extérieur, et de traversées isolantes rapportées pour la liaison électrique à l'élément,
- ledit élément (14) étant un élément actif intégré audit substrat;
- les plages métalliques (16) sont situées sur une face du substrat opposée à la face où est situé ledit élément actif intégré et sont apparentes à l'extérieur dudit composant et revêtues d'un dépôt assurant la biocompatibilité;
- le substrat comprend des vias (20) de liaison desdites plages métalliques à des conducteurs en contact avec ledit élément actif intégré (14), ces vias étant des vias gravés au travers du substrat et remplis d'un métal; et - ledit couvercle (22) est une couche de fermeture qui est réalisée directement sur le substrat par une technique de type Thin Film Packaging (TFP) qui comporte un évidement réservé côté interne, face à l'élément actif intégré (14).

Sur les figures, la référence 10 désigne de façon générale un composant, qui comprend un substrat 12, notamment un substrat en silicium ou autre matériau semiconducteur ou en quartz, intégrant un élément actif tel qu'un capteur 14. Ce capteur peut être par exemple un capteur de pression sanguine (de type SAW ou BAW) ou un accéléromètre (piézoélectrique ou à base de MEMS) destiné en particulier à mesurer l'accélération endocardiaque (EA) à l'extrémité d'une sonde implantée dans l'apex du ventricule.

L'épaisseur du substrat 12 peut être réduite par rodage à une valeur très faible, jusqu'à 200µm environ, permettant de disposer d'un composant de très faible épaisseur, aisé à intégrer dans des sondes implantées de très faibles dimensions.

La liaison électrique au capteur 14 est réalisée par des plages conductrices 16 apparentes à l'extérieur du composant et revêtues d'un dépôt assurant la biocompatibilité, par exemple un dépôt d'or. Ces plages de contact 16 sont situées sur une face du substrat 12 opposée à la face où est intégré le capteur 14, et la liaison au conducteur 18 en contact avec le capteur 14 est assurée par l'intermédiaire de vias 20, par exemple réalisées par gravure plasma au travers du substrat 12 puis remplis par dépôt électrolytique de cuivre ou tout autre métal approprié ; une telle technologie est décrite par exemple dans le US 2004/0259325 A1, auquel on pourra se référer pour plus de détails.

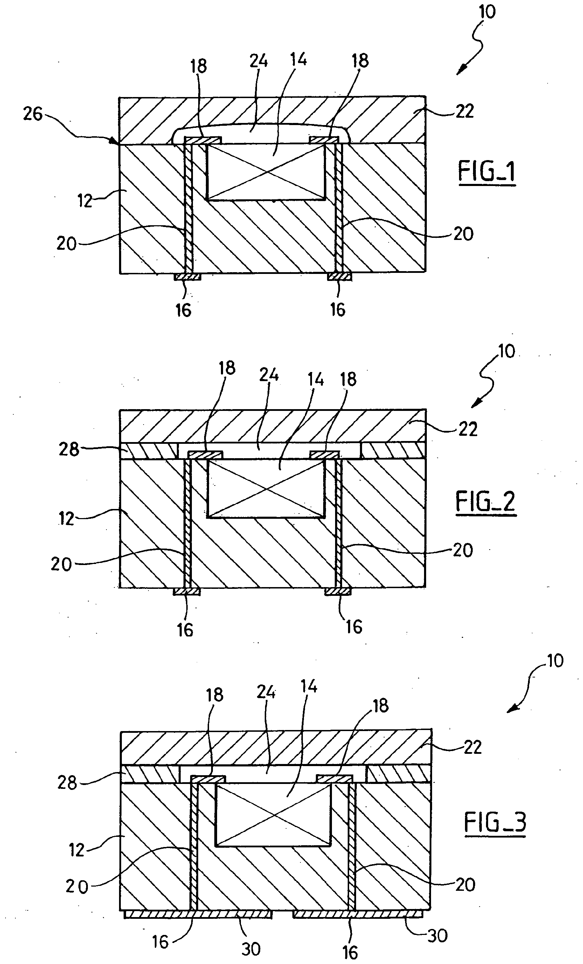

Le substrat 12 est fermé, du côté où est situé le capteur 14, par un couvercle 22, également en silicium ou quartz, qui, dans l'exemple illustré figure 1, comporte un évidement 24 réservé côté interne, face au capteur. Dans l'exemple de la figure 1, le substrat 12 et le couvercle 22 sont directement scellés l'un à l'autre par leurs faces en vis-à-vis, à l'interface 26. Une telle technique de scellement direct silicium-sur-silicium est décrite par exemple dans le US 6 979 597 A1, auquel on pourra se référer pour de plus amples détails.

Cette technique de réalisation des prises de contact présente plusieurs avantages majeurs :
- elle permet de réaliser des contacts de très faible résistance, grâce au remplissage par un métal ;
- ce remplissage de métal permet d'assurer une excellente herméticité entre le volume intérieur et la cavité 24 où se situe le capteur 14, et la face opposée où se trouvent les plages de contact 16,
- enfin, cette configuration est parfaitement compatible avec un traitement collectif, le substrat 12 et le couvercle 22 pouvant être sciés ensemble de manière à individualiser le composant 10.

Dans la variante de la figure 2, le substrat 12 et le couvercle 22 ne sont pas scellés directement l'un à l'autre, mais par l'intermédiaire d'un anneau de scellement intercalaire 28, par exemple un anneau en métal ou alliage métallique biocompatible, notamment à base d'or ou de palladium ; cette technologie est par exemple décrite dans le US-A-6 118 181 auquel on pourra se référer pour de plus amples détails. Le matériau de l'anneau de scellement peut être également un verre approprié, à faible taux d'impuretés.

Lorsque du silicium est utilisé comme matériau pour le substrat 12 et le couvercle 22, ce silicium est avantageusement dopé au bore, ce dopage ayant la propriété d'améliorer sa biocompatibilité, comme décrit notamment dans le US-A-6 968 743.

Dans la variante de la figure 3, les plages 16 formant électrodes de contact sont prolongées et configurées suivant un motif approprié 30 de manière à former une antenne (dipôle, boucle, ...) permettant d'assurer une liaison non galvanique avec le capteur 14. Ce dernier peut alors être téléalimenté et incorporé à un composant totalement autonome, dépourvu de liaison filaire. Un tel composant pourvu de fonctions de communication RF peut notamment constituer un dispositif d'identification radiofréquence (RFID) implantable, opérant dans des bandes de fréquences telles que la bande MICS (*Medical Implants Communication System*) 402-405 MHz ou les bandes banalisées publiques ISM (*Industriel, Scientifique et Médical*) 863-870 MHz, 902-928 MHz et 2,4 GHz utilisées par les dispositifs médicaux, autorisant l'interrogation de l'élément actif 14 à distance par une technique de "télémétrie RF".

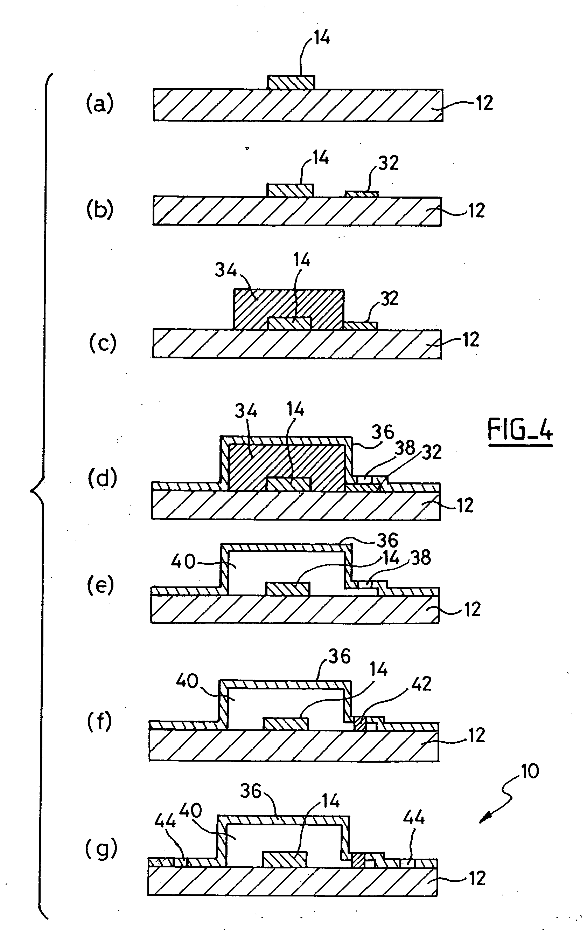

La figure 4 illustre les différentes étapes d'un procédé de type *"Thin Film Packaging"* (TFP).

Le capteur est alors protégé par un capot mince réalisé directement sur le substrat par des étapes de dépôt et de gravure, en lieu et place d'un capot rapporté scellé, comme dans les cas illustrés figures 1 à 3.

La première étape (étape a) consiste à réaliser le capteur 14 sur le substrat 12.

Ensuite (étape b), une première couche sacrificielle 32, de faible épaisseur, est déposée localement à proximité, mais à distance, du capteur 14. Une autre couche sacrificielle 34, de forte épaisseur, est ensuite déposée (étape c), qui vient englober le capteur 14, jusqu'à l'endroit de la première couche sacrificielle 32.

L'étape suivante (étape d) consiste à déposer un film ou couche mince de fermeture 36, qui constituera ultérieurement le couvercle du composant sur l'ensemble ainsi formé. Une ouverture 38 est pratiquée dans cette couche 36 au droit de la première couche sacrificielle 32. Pour la réalisation du capot mince 36, divers matériaux appropriés peuvent être employés qui assurent une herméticité au degré souhaité, par exemple des dépôts de film de nitrure par technique PECVD.

L'étape suivante (étape e) consiste à éliminer les deux couches sacrificielles 32 et 34 par attaque au travers de l'ouverture 38. Ceci permet la formation autour du capteur 14 d'un volume interne libre 40 clos par la couche 36 à l'exception de l'ouverture 38.

Cette ouverture 38 est ensuite obturée (étape f) par un dépôt diélectrique 42 permettant d'assurer l'herméticité du volume intérieur 40.

L'étape finale (étape g) consiste à réaliser à la périphérie du volume 40 entourant le capteur 14 les ouvertures 44 d'accès aux contacts (non représentés) de liaison électrique à ce capteur. On notera que dans ce cas les contacts sont pris sur la même face du substrat 12 que celle intégrant le capteur 14, à la différence des figures 1 à 3 où les contacts étaient pris sur la face opposée.

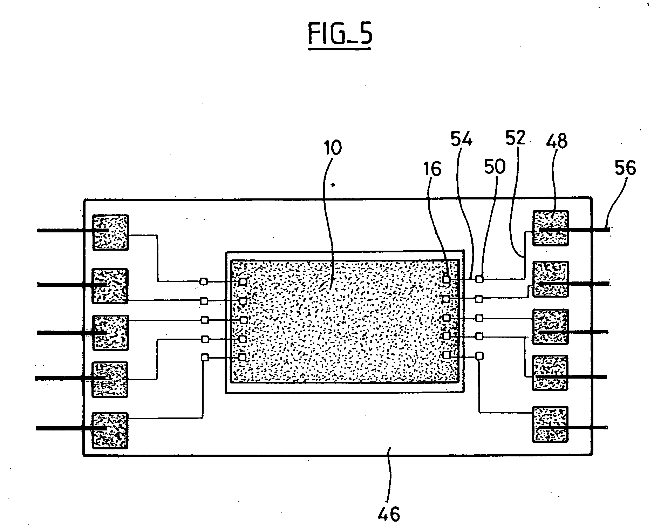

La figure 5 montre, en plan, un exemple d'un composant 10 collé sur un support 46 tel qu'un circuit souple ou flexible. Ce support 46 porte des surfaces de liaison 48 reliées à des plages ou "pads" via des interconnexions 52 déposées sur le substrat. Les plages 50 sont situées à proximité, et en vis-à-vis, des plages de contact homologues 16 du circuit 10, auxquelles elles sont reliées par des fils de "bonding" 54. De cette manière, chaque plage de contact 16 du circuit est électriquement reliée à l'une des surfaces 48, sur laquelle pourra être soudée l'extrémité d'un microcâble 56 de liaison à un dispositif distant.

## Revendications

1. Un composant biocompatible implantable dans le corps humain incorporant, encapsulé de manière hermétique, un élément de type capteur de mesure d'un paramètre physiologique, microsystème électromécanique ou circuit électronique, ce composant (10) comprenant
- un substrat de base (12) en silicium ou quartz ayant sur l'une de ses faces l'élément (14), et pourvu de plages métalliques (16), biocompatibles avec l'environnement extérieur, formées sur une surface libre de ce même substrat (16), ces plages étant électriquement reliées à l'élément par des liaisons électriques (20) intégrées au substrat ; et
- un couvercle (22) en silicium ou quartz recouvrant et fermant périphériquement le substrat de manière hermétique, du côté de la face intégrant l'élément,
ce composant étant essentiellement dépourvu de boîtier métallique d'isolement de l'élément d'avec l'environnement extérieur, et de traversées isolantes rapportées pour la liaison électrique à l'élément,
**caractérisé en ce que** :
- ledit élément (14) est un élément actif intégré audit substrat (12)
- lesdites plages métalliques (16) sont situées sur une face du substrat opposée à la face où est situé ledit élément actif intégré (14) et sont apparentes à l'extérieur dudit composant et revêtues d'un dépôt assurant la biocompatibilité ;
- le substrat comprend des vias (20) de liaison desdites plages métalliques (16) à des conducteurs (18) en contact avec ledit élément actif intégré (14), ces vias étant des vias gravés au travers du substrat (12) et remplis d'un métal ; et
- ledit couvercle (22) est une couche de fermeture qui est réalisée directement sur le substrat (12) par une technique de type Thin Film Packaging qui comporte un évidement (24) réservé côté interne, face à l'élément actif intégré (14).

2. Le composant biocompatible implantable de la revendication 1, dans lequel lesdites plages métalliques (16) sont des plages revêtues d'or.

3. Le composant biocompatible implantable de la revendication 1, dans lequel l'élément actif intégré (14) comprend des circuits radiofréquence et/ou téléalimentés, et dans lequel au moins certaines des plages métalliques (16) sont des plages dont les dimensions et la configuration respective sont choisies de manière à former une antenne (30).

4. Le composant biocompatible implantable de la revendication 1, dans lequel le matériau du substrat (12) et du couvercle (22) est un silicium dopé au bore.

5. Le composant biocompatible implantable de la revendication 1, dans lequel substrat (12) et couvercle (22) sont directement scellés l'un à l'autre par leurs faces en vis-à-vis.

## Patentansprüche

1. Biokompatible Komponente, die in den menschlichen Körper implantierbar ist und die, hermetisch gekapselt, in Form eines elektromechanischen Mikrosystems oder einer elektronischen Schaltung, ein Sensorelement zum Messen eines physiologischen Parameters enthält, wobei diese Komponente (10) umfasst
- ein Basissubstrat (12) aus Silizium oder Quarz, das auf einer seiner Seiten das Element (14) aufweist und mit Metallbereichen (16) versehen ist, die mit der äußeren Umgebung biokompatibel sind und die auf einer freien Oberfläche des gleichen Substrats (16) ausgebildet sind, wobei diese Bereiche durch elektrische Verbindungen (20), die in das Substrat integriert sind, elektrisch mit dem Element verbunden sind; und
- eine Abdeckung aus Silizium oder Quarz (22), die das Substrat auf der Seite der das Element integrierenden Fläche umlaufend hermetisch abdeckt und umschließt,
wobei diese Komponente im Wesentlichen frei von einem Metallgehäuse zum Isolieren des Elements von der äußeren Umgebung und von isolierenden Durchführungen ist, die zur elektrischen Verbindung mit dem Element angebracht sind,
**dadurch gekennzeichnet, dass**:
- das Element (14) ein aktives Element ist, das in das Substrat (12) integriert ist;
- die Metallbereiche (16) auf einer Seite des Substrats angeordnet sind, die der Seite gegenüberliegt, auf der sich das integrierte aktive Element (14) befindet, und außerhalb der Komponente sichtbar sind und mit einer Beschichtung überzogen sind, die die Biokompatibilität gewährleistet;
- das Substrat Durchkontaktierungen (20) zum Verbinden der metallischen Bereiche (16) mit Leitern (18) in Kontakt mit dem integrierten aktiven Element (14) umfasst, wobei die Durchkontaktierungen Durchkontaktierungen sind, die durch das Substrat (12) geäzt und mit einem Metall gefüllt sind; und
- die Abdeckung (22) eine Verschlussschicht ist, die direkt auf dem Substrat (12) in einem Verfahren vom Typ Dünnschichtverpackung hergestellt wird, welche eine Aussparung (24) aufweist, die innen dem integrierten aktiven Element (14) zugewandt ist.

2. Implantierbare biokompatible Komponente nach Anspruch 1, wobei die Metallbereiche (16) vergoldete Bereiche sind.

3. Implantierbare biokompatible Komponente nach Anspruch 1, wobei das integrierte aktive Element (14) hochfrequente und/oder ferngespeiste Schaltungen umfasst, und wobei mindestens einige der Metallbereiche (16) Bereiche sind, deren jeweilige Abmessungen und Konfiguration ausgewählt sind, um eine Antenne (30) zu bilden.

4. Implantierbare biokompatible Komponente nach Anspruch 1, wobei das Material des Substrats (12) und der Abdeckung (22) bordotiertes Silizium ist.

5. Implantierbare biokompatible Komponente nach Anspruch 1, wobei Substrat (12) und Abdeckung (22) durch ihre zugewandten Seiten direkt miteinander verbunden sind.

## Claims

1. An implantable biocompatible component that is implantable in the human body and that incorporates, as packaged in hermetically sealed manner, an element of the type selected from the group comprising a sensor for measuring a physiological parameter, a micro-electro-mechanical system (MEMS), and an electronic circuit, said component (10) comprising:
- a base substrate (12) made of silicon or quartz, having the element (14) on one of its faces, and provided with metal pads (16) that are biocompatible with the outside environment, and that are formed on a free surface of the same substrate (16), said pads being electrically connected to the element by electrical connections (20) integrated into the substrate; and
- a cover (22) that is made of silicon or quartz and that covers and peripherally closes the substrate in hermetically sealed manner, on the same side as the face that integrates the element;
said component being essentially devoid of any metal casing for insulating the element from the outside environment, and devoid of any separate insulating feedthroughs for electrical connection to the element;
said implantable biocompatible component being **characterized in that**:
- said element (14) is an active element integrated into said substrate (12);
- said metal pads (16) are situated on a face of the substrate that is opposite from the face on which said integrated active element (14) is situated, and they are apparent on the outside of said component and coated with deposits procuring biocompatibility;
- the substrate is provided with through holes or "vias" (20) for connecting said metal pads (16) to conductors (18) in contact with said integrated active element (14), said vias being vias etched through the substrate (12) and filled with a metal; and
- said cover (22) is a closure layer that is formed directly on the substrate (12) by using a technique of the Thin Film Packaging (TFP) type and that is provided with a cavity (24) left in its inside face, facing the integrated active element (14).

2. The implantable biocompatible component of claim 1, wherein said metal pads (16) are gold-plated pads.

3. The implantable biocompatible component of claim 1, wherein the integrated active element (14) includes radiofrequency and/or remotely powered circuits, and wherein at least some of the metal pads (16) are pads having respective dimensions and configurations chosen in such a manner as to form an antenna (30).

4. The implantable biocompatible component of claim 1, wherein the material of the substrate (12) and of the cover (22) is a boron-doped silicon.

5. The implantable biocompatible component of claim 1, wherein the substrate (12) and the cover (22) are directly bonded to each other via their mutually facing faces.
